# EUROPÄISCHE PATENTSCHRIFT

(11) **EP 0 390 780 B1**
(45) Veröffentlichungstag und Bekanntmachung des Hinweises auf die Patenterteilung: **06.12.1995**
(21) Anmeldenummer: 88907633.7
(22) Anmeldetag: 13.09.1988
(51) Int. Cl.: F02P 15/00, H01T 15/00, H01L 25/07, H01L 29/74

(54) **HOCHSPANNUNGSSCHALTER**
HIGH-VOLTAGE SWITCH
COMMUTATEUR A HAUTE TENSION

(30) Priorität: 18.09.1987 DE 3731393
(43) Veröffentlichungstag der Anmeldung: 10.10.1990
(73) Patentinhaber: ROBERT BOSCH GMBH, 70442 Stuttgart (DE)
(72) Erfinder: BENEDIKT. Walter, D-7014 Kornwestheim (DE); HERDEN, Werner, D-7016 Gerlingen (DE)
(86) Internationale Anmeldenummer: DE8800566
(87) Internationale Veröffentlichungsnummer: WO8902528

(56) Entgegenhaltungen:
- US-A- 3 476 993
- US-A- 3 571 650
- US-A- 4 411 247
- US-A- 4 727 891
- Patent Abstracts of Japan, Vol. 11, No. 320 (E-550), October 1987, &JP-A-62-109352

## Beschreibung

### Stand der Technik

Die Erfindung betrifft einen Hochspannungsschalter für Zündanlagen von Verbrennungsmotoren.

Es ist bekannt, daß Zündkerzen in Verbrennungsmotoren besonders beim Kaltstart verrußen. Auch wenn Zündkerzen mit hohem Wärmewert in einem Verbrennungsmotor verwendet werden, tritt eine Verrußung ein. Die Rußschicht auf einer Zündkerze führt zu einem Nebenschluß, der während des Anstiegs der Zündspannung an der Zündkerze einen Energieabfluß verursacht. Dadurch wird häufig die Zündspannung nicht erreicht, so daß Zündaussetzer auftreten.

Zur Lösung dieses Problems dienen Vorfunkenstrecken in den Zündanlagen, die in einen Glaskolben eingeschmolzene Elektroden aufweisen und die für einen Funken bei einer vorgegebenen Spannung sorgen. Nachteil dieser Vorfunkenstrecken ist jedoch, daß sich die Zündspannung der Vorfunkenstrecke von Funken zu Funken und während der Lebensdauer der Vorfunkenstrecke ändert. Dies beruht auf Abbrand der Elektroden und darauf, daß sich das die Elektroden umgebende Gas im Laufe der Zeit verändert.

Aus der US-PS 4,411,247 ist bereits ein verteilerloses Zündsystem für Brennkraftmaschinen bekannt geworden, das auf der Hochspannungseite als Dioden ausgebildete Halbleiter aufweist, so daß bei einer ruhenden Hochspannungsverteilung in Abhängigkeit von der Stromflußrichtung in der Primärspule jeweils nur die Zündkerzen gezündet werden, die einen Halbleitergleichrichter vorgeschaltet haben, der für die dann auftretende Spannung in Durchlaßrichtung liegt.

Aus der US-PS 3,476,993 ist ein Thyristor bekannt geworden, bei dem die Kathode über durchgehende Kontaktierungen innerhalb der Halbleiterchips mit dem Gate verbunden ist. In Schaltrichtung betrieben, kippt dieser Thyristor in den leitenden Zustand. Aus der US-PS 3,571,650 ist eine Diodenkaskade bekannt geworden. Um hohe Schaltspannungen zu erzielen, werden hierbei entsprechend viele hintereinandergeschaltete Dioden verwendet.

### Vorteile der Erfindung

Der erfindungsgemäße Hochspannungsschalter der eingangs genannten Art mit den Merkmalen des Hauptanspruchs hat demgegenüber den Vorteil, daß die Zündspannung sehr genau vorwählbar ist und daß Einflüsse von Nebenflüssen an der Zündkerze praktisch eliminiert werden. Durch die Verwendung einer Thyristorkaskade wird erreicht, daß die Zündspannung erst ab einer wählbaren hohen Spannung von beispielseise 20 kV an die Zündkerze gelegt wird. Dadurch können sich Nebenschlüsse während des Anstiegs der Zündspannung nicht auswirken. Auch Kerzen mit zu hohem Wärmewert zünden selbst bei Kaltstarts problemlos.

Durch die in den Unteransprüchen aufgeführten Maßnahmen sind vorteilhafte Weiterbildungen und Verbesserungen des im Hauptanspruch angegebenen Hochspannungsschalters möglich. Durch die Verwendung von Kaskaden läßt sich in bekannter Weise die Spannungsfestigkeit erhöhen, so daß bei einer Schwachspannung von 1 kV pro Diode und einer Zündspannung von 20 kV häufig 20 dieser Bauelemente hintereinandergeschaltet werden.

### Zeichnung

Ein Ausführungsbeispiel der Erfindung wird im folgenden anhand von Figuren näher erläutert. Es zeigen:
Figur 1 ein Prinzipschaltbild einer Zündanlage und
Figur 2 den Spannungsverlauf an der Zündkerze und an der Sekundärwicklung einer Zündspule der Zündanlage gemäß Figur 1.

### Beschreibung der Ausführungsbeispiele

Der Hochspannungsschalter ist allgemein in Verbindung mit Hochspannungsverbrauchern verwendbar. Im folgenden wird beispielhaft der Einsatz des Hochspannungsschalters in einer Zündanlage eines Kraftfahrzeugs beschrieben.

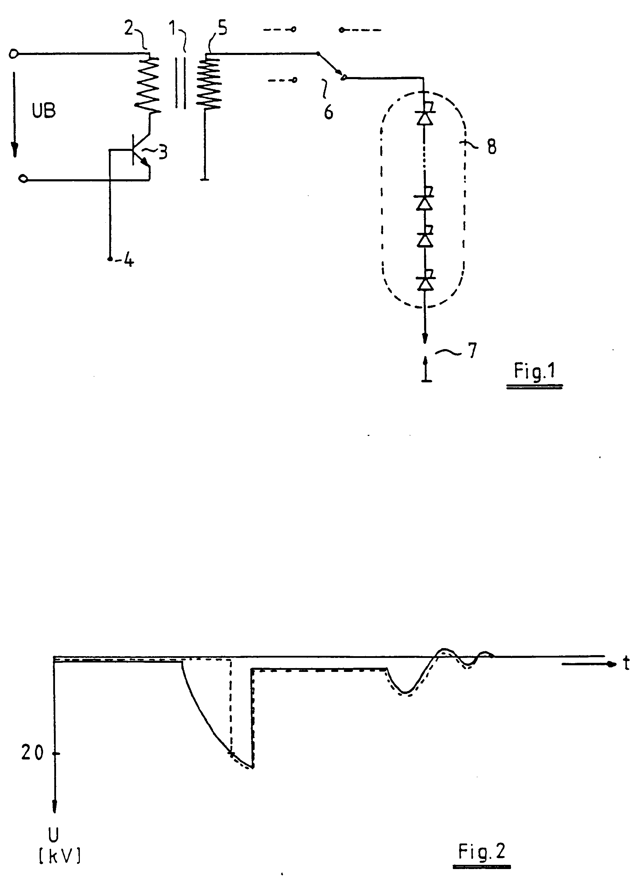

Figur 1 zeigt eine Zündspule 1, deren Primärwicklung 2 über einen Steuertransistor 3 an eine Spannungsversorgung U_{B}, beispielsweise an die hier nicht dargestellte Batterie eines Kraftfahrzeugs angeschlossen ist. Der Steuertransistor 3 wird auf bekannte Weise über eine Steuerklemme 4 von einem Steuergerät angesteuert.

Die Sekundärwicklung 5 der Zündspule 1 ist mit einem Verteiler 6 verbunden, der die einzelnen Hochspannungsverbraucher, hier die Zündkerzen 7 eines Kraftfahrzeugs ansteuert. Unmittelbar vor den Zündkerzen, von denen hier zur Vereinfachung nur eine dargestellt ist, ist jeweils ein als Kippdiodenkaskade 8 ausgebildetes spannungsgesteuertes, elektronisches Hochspannungsschaltelement angeordnet.

Bei den Kippdioden handelt es sich um zweipolige Thyristoren, nämlich um Thyristoren, bei denen Gate und Kathode über einen Widerstand von 0 bis ∞ Ω miteinander verbunden sind. Bei dem hier beschriebenen Ausführungsbeispiel liegt eine unmittelbare Verbindung der genannten Thyristoranschlüsse vor. Die Kennlinien dieser Kippdioden entsprechen denen von Thyristoren: Bei ansteigender Spannung sperrt das Bauteil bis zu einer spezifischen Spannung U_{K} von beispielsweise 1 kV. Bei Überschreiten der sog. Kippspannung U_{K} wird das Bauteil schlagartig leitend, wobei dann lediglich die Durchlaßspannung von z.B. U_{D} = 1 bis 2 V abfällt. Mehrere dieser Kippdioden werden hintereinandergeschaltet, so daß sich deren Kippspannung addiert und so eine beliebige Kippspannung der Kaskade einstellbar ist. Für eine Kippspannung von beispielsweise 20 kV werden 20 dieser Kippdioden hintereinandergeschaltet.

Die Kippdiodenkaskaden werden dadurch hergestellt, daß Halbleiterscheiben beidseitig metallisiert, aufeinandergelegt und unter Wärmeeinwirkung miteinander verbacken werden. Sollen 20 Kippdioden hintereinandergeschaltet werden, werden 20 dieser Scheiben bzw. Wafer miteinander verbacken. Aus diesem Verbund werden anschließend Säulen herausgesägt, die beispielsweise 10 mm hoch sind und einen Querschnitt von 1x1 mm aufweisen.

Diese Säulen können an einem beliebigen Ort auf der Sekundärseite einer Zündspule, also irgendwo zwischen Zündspule und Zündkerze eingebaut werden. Werden sie im Bereich zwischen Zündspule und Verteilerfinger eingebaut, so ist nur eine Kippdiodenkaskade erforderlich im Vergleich zum Einbau im Bereich zwischen Verteileraußendomen und Zündkerzen, wo pro Zylinder eine Kippdiodenkaskade erforderlich ist. Je dichter die Kippdiodenkaskade an der Zündkerze angeordnet wird, umso mehr gleichen sich die Höhe des erzielten Spannungssprungs an der Zündkerze und die Höhe der Kippspannung der Kippdiodenkaskade. Wird die Kaskade z.B. in die Zündspule eingebaut, so muß ihre Kippspannung wesentlich höher ausgelegt werden als der gewünschte Spannungssprung an der Zündkerze sein soll.

So ergeben sich günstige Einbauorte wie folgt:
1. Bei Verwendung von einer Kippdiodenkaskade im Verteilerfinger oder Verteilermitteldom.
2. Bei Verwendung von mehreren Kippdiodenkaskaden entsprechend der Zylinderzahl in der Zündkerze oder vorzugsweise im Zündkerzenstecker, da dieser im Vergleich zur Zündkerze kein Verschleißteil darstellt.

Beim Einbau wird die Kippdiodenkaskade im allgemeinen mit Kunststoff oder Glas vergossen.

In Figur 2 sind die während eines Zündvorganges an der Zündkerze anliegende Spannung gestrichelt und die dabei auf der Sekundärseite der Zündspule auftretende Spannung mit einer durchgezogenen Linie dargestellt.

Die Funktion des Hochspannungsschalters wird im folgenden näher erläutert:

Die Funktion der Zündspule 1 und die des Verteilers 6 sind bekannt. Hierauf wird nicht weiter eingegangen. Der in Figur 1 angedeutete Verteiler 6 verbindet die Zündkerzen 7 mit der Zündspule.

Durch Abschalten des durch die Primärwicklung 2 der Zündspule 1 fließenden Stromes mittels des Steuertransistors 3 ergibt sich an der Sekundärwicklung 5 der Zündspule der in Figur 2 durchgezogen dargestellte Spannungsverlauf. Im vorliegenden Fall wird von einer Zündspannung von ca. 20 kV ausgegangen. Dieser Wert wird nach einer Anstiegszeit von ca. 40 »s erreicht. Durch Nebenschlüsse, beispielsweise durch Feuchtigkeit oder Ruß kann während dieser Anstiegszeit ein so großer Strom abgeleitet werden, daß die Zündspannung nicht mehr erreicht wird und Zündaussetzer eintreten.

Mit Hilfe der Kippdiodenkaskaden wird ein sog. Aufsteilerungseffekt erzielt: Die Spannung an der Kaskade kann bis zu der durch die Anzahl der übereinander gestapelten Bauteile vorgegebenen Kipp- bzw. Zündspannung ansteigen, ohne daß Spannung an die Zündkerze gelegt wird. Dies liegt an der Sperrwirkung der Kippdioden. Bis zum Erreichen der Zündspannung, die der Summe aller Kipp- oder Sperrspannungen entspricht, können sich Nebenschlüsse durch Verunreinigungen folglich nicht auswirken. Sobald die Zündspannung erreicht ist, schaltet die Kippdiodenkaskade schlagartig durch, so daß die Zündspannung an der Zündkerze anliegt und ein Funke überspringt.

Die Kippdiodenkaskade kann grundsätzlich an einer beliebigen Stelle auf der Sekundärseite der Zündspule angeordnet sein. Aufgrund der Eigenkapazität der Zuleitungen zu den Zündkerzen wird der Aufsteilerungseffekt mit zunehmender Leitungslänge jedoch geschmälert. Daher ist die Kaskade vorzugsweise direkt im Zündkerzenstecker vorgesehen.

Mit Hilfe dieses Aufsteilerungseffekts lassen sich für die an der Zündkerze anliegenden Spannung Anstiegszeiten von einigen zehn bis einigen hundert ns, z.B. 50 ns erreichen. Dadurch werden die Zündkerzen unempfindlich gegenüber Nebenschlüssen, was besonders die Kaltstarteigenschaften der Brennkraftmaschine verbessert.

Überdies hat sich herausgestellt, daß mit Hilfe dieser Kippdiodenkaskade die Wäremewertdimensionierung von Zündkerzen unkritisch ist. Es ist bekannt, daß "kalte Kerzen", also Kerzen mit zu hohem Wärmewert zum Verrußen neigen, was zu Nebenschlüssen führt. Zündaussetzer und Kaltstartprobleme sind die Folge. Aufgrund des verbesserten Spannungsverlaufs an der Zündkerze werden diese Probleme eliminiert.

Der erfindungsgemäße spannungsgesteuerte, elektronische Hochspannungsschalter führt auch zur Gewichts- und Kostenreduzierung. Bislang mußte die Zündspule immer so groß ausgelegt werden, daß auch unter ungünstigen Bedingungen, also bei Stromabfluß über Nebenschlüsse, ausreichend Energie zur Erzeugung eines Zündfunkens zur Verfügung stand. Um dies zu gewährleisten, waren große und schwere Zündspulen sowie hohe Abschaltströme nötig, was zu aufwendigen und teuren Anlagen führte. Durch den Aufsteilerungseffekt wird auch mit kleineren, energieschwächeren Zündanlagen ein Zündfunke sicher erzeugt.

Dadurch daß der Zündfunke nicht mehr so energiereich zu sein braucht, wird auch der Verschleiß der Elektroden an den Zündkerzen wesentlich vermindert.

Zur Erzeugung des Zündfunkens wird üblicherweise der von dem Schalttransistor 3 gesteuerte Abschaltstrom in der Zündspule verwendet. Die beschriebene Kippdiodenkaskade dient der Aufsteilerung der dabei auf der Sekundärseite der Zündspule entstehenden Spannung. Sie kann aber auch dazu herangezogen werden, positive Einschaltspannungsimpulse, die auch Werte von über 2 kV erreichen können, abzublocken. Diese treten bei sogenannten "ruhenden" Hochspannungsverteilungen auf, also bei Anwendungen ohne rotierende Verteilerfunkenstrecke. Dazu müssen Kippdioden mit symmetrischer Kennlinie verwendet werden, die dann auch bei diesen positiven Spannungen im Sperrbereich bleiben.

Es ist schließlich noch festzuhalten, daß die beschriebene Kippdiodenkaskade nicht nur bei der Erstausstattung von Fahrzeugen verwendet, sondern auch ohne weiteres nachträglich eingebaut werden kann.

## Patentansprüche

1. Hochspannungsschalter für Zündanlagen von Verbrennungsmotoren für Kraftfahrzeuge mit einem spannungsgeteuerten elektronischen Hochspannungselement (8), das für den Einbau auf der Sekundärseite (5) einer Zündspule (1) an einer beliebigen Stelle zwischen Zündspule (1) und Zündkerze (7) geeignet ist, dadurch gekennzeichnet, daß als Hochspannungsschaltelement eine Thyristorkaskade (8) verwendet wird, daß die Thyristorkaskade (8) aus Kippdioden zusammengesetzt ist, bei denen jeweils das Gate und Kathode miteinander verbunden sind, was innerhalb des Halbleiterchips des Thyristors realisiert ist und daß die Thyristorkaskade (8) bei einer vorwählbaren oder vorgegebenen Spannung vom Sperrzustand schlagartig in den leitenden Zustand übergeht.

2. Hochspannungsschalter nach Anspruch 1, dadurch gekennzeichnet, daß die Kaskade (8) aus einer Vielzahl von beidseitig metallisierten Halbleiterelementen besteht, die miteinander verbunden sind.

3. Hochspannungsschalter nach Anspruch 2, dadurch gekennzeichnet, daß die Halbleiterelemente aus übereinander gestapelten Halbleiterscheiben heraussägbar sind.

4. Hochspannungsschalter nach Anspruch 1, dadurch gekennzeichnet, daß das Hochspannungsschaltelement (8) in den Verteilerfinger, den Verteilermitteldom oder den Verteilermitteldomstecker eingegossen ist.

5. Hochspannungsschalter nach einem der Ansprüche 1 bis 3, dadurch gekennzeichnet, daß das Hochspannungselement (8) in einer Zündkerze (7) eingegossen ist.

6. Hochspannungsschalter nach einem der Ansprüche 1 bis 5, dadurch gekennzeichnet, daß als Vergußmasse für die Halbleiterelemente Kunststoff, Glas oder keramischer Kitt verwendet werden.

## Claims

1. High-voltage switch for ignition systems of internal combustion engines for motor vehicles with a voltage-controlled, electronic high-voltage element (8) which is suitable for installation on the secondary side (5) of an ignition coil (1) at any desired point between the ignition coil (1) and the spark plug (7), characterized in that a thyristor cascade (8) is used as high-voltage switching element, in that the thyristor cascade (8) is composed of breakover diodes in which in each case the gate and cathode are connected to one another, which is realized inside the semiconductor chip of the thyristor, and in that the thyristor cascade (8) suddenly switches over from the blocking state to the conductive state at a preselectable or predetermined voltage.

2. High-voltage switch according to Claim 1, characterized in that the cascade (8) comprises a plurality of semiconductor elements which are metallized on both sides and are connected to one another.

3. High-voltage switch according to Claim 2, characterized in that the semiconductor elements can be sawed out of semiconductor wafers stacked one on top of the other.

4. High-voltage switch according to Claim 1, characterized in that the high-voltage switching element (8) is cast into the distributor finger, the centre distributor dome or the centre distributor dome plug.

5. High-voltage switch according to one of Claims 1 to 3, characterized in that the high-voltage element (8) is cast into a spark plug (7).

6. High-voltage switch according to one of Claims 1 to 5, characterized in that plastic, glass or ceramic filling compound are used as sealing compound for the semi-conductor elements.

## Revendications

1. Commutateur à haute tension pour systèmes d'allumage de moteurs à combustion interne pour véhicules à moteur avec un élément électronique à haute tension (8) à tension commandée qui est approprié pour être monté sur le côté secondaire (5) d'une bobine d'allumage (1) à n'importe quel endroit entre la bobine d'allumage (1) et la bougie d'allumage (7), commutateur à haute tension caractérisé en ce que l'on utilise comme élément à haute tension une cascade de thyristors (8), en ce que la cascade de thyristors (8) est composée de diodes basculantes, dans le cas desquelles la grille et la cathode sont respectivement réunies l'une à l'autre, ce qui est réalisé à l'intérieur de la puce semi-conductrice du thyristor et en ce que la cascade de thyristors (8) passe dans le cas d'une tension que l'on peut choisir à l'avance ou qui est prédéfinie de l'état bloqué brusquement à l'état conducteur.

2. Commutateur à haute tension selon la revendication 1, caractérisé en ce que la cascade (8) consiste en une multiplicité d'éléments semi-conducteurs métallisés des deux côtés, qui sont réunis les uns aux autres.

3. Commutateur à haute tension selon la revendication 2, caractérisé en ce que les éléments semiconducteurs peuvent être sciés à partir de disques semiconducteurs empilés les uns sur les autres.

4. Commutateur à haute tension selon la revendication 1, caractérisé en ce que l'élément à haute tension (8) est incorporé par coulée dans le doigt du distributeur d'allumage, dans le dôme du distributeur d'allumage ou dans la fiche de connexion au dôme central du distributeur d'allumage.

5. Commutateur à haute tension selon l'une des revendications 1 à 3, caractérisé en ce que l'élément à haute tension (8) est coulé dans une bougie d'allumage (7).

6. Commutateur à haute tension selon l'une des revendications 1 à 5, caractérisé en ce que l'on utilise comme masse de coulée pour les éléments semi-conducteurs de la matière plastique, du verre ou un lut en matière céramique.
